# EUROPÄISCHE PATENTSCHRIFT

(11) **EP 1 327 699 B1**
(45) Veröffentlichungstag und Bekanntmachung des Hinweises auf die Patenterteilung: **27.10.2004**
(21) Anmeldenummer: 02028377.6
(22) Anmeldetag: 18.12.2002
(51) Int. Cl.: C23C 14/26, C23C 14/24, C30B 23/06

(54) **Verdampferschiffchen für eine Vorrichtung zur Beschichtung von Substraten**
Evaporator boat for a substrate-coating apparatus
Nacelle d'évaporation pour dispositif de revêtement des substrats

(30) Priorität: 12.01.2002 DE 10200909
(43) Veröffentlichungstag der Anmeldung: 16.07.2003
(73) Patentinhaber: Applied Films GmbH & Co. KG, 63755 Alzenau (DE)
(72) Erfinder: Fischer, Günther, 63755 Alzenau (DE); Klemm, Günter, 61667 Nidda (DE); Weis, Andreas, 63457 Hanau (DE)
(74) Vertreter: Hebing, Norbert

(56) Entgegenhaltungen:
- EP-A- 0 792 946
- DE-A- 4 139 792
- DE-A- 4 427 618
- DE-B- 1 088 778
- DE-C- 973 280

## Beschreibung

Die Erfindung betrifft ein Verdampferschiffchen für eine Vorrichtung zur Beschichtung von Substraten in einer Beschichtungskammer, wobei das Verdampferschiffchen durch direkten Stromdurchgang beheizbar ist und eine einen Boden aufweisende Kavität zur Aufnahme einer Schmelze des zu verdampfenden Metalles sowie eine Zuführung für das von dem Verdampferschiffchen zu schmelzende und zu verdampfende Metall in Form von Draht hat.

Ein Verdampferschiffchen der vorstehenden Art ist Gegenstand der DE 41 39 792 A1. Wie bei solchen Verdampferschiffchen üblich, wird der abzuschmelzende Draht im mittleren Bereich des Verdampferschiffchens in seine Kavität geführt, so dass sein Ende dort erwärmt und abgeschmolzen wird. Die Schrift befasst sich mit dem Problem, dass es durch das Abtropfen von Metall von dem zugeführten Draht zu Spritzern kommen kann, die zu Fehlstellen auf dem zu bedampfenden Substrat führen können. Bei Bandbeschichtungsanlagen können Spritzer sogar die Ursache für Bandrisse sein. Gemäß der genannten DE 41 39 792 A1 versucht man die Gefahr der Bildung von Spritzern dadurch zu beheben, dass das Verdampferschiffchen und zugleich seine Kavität im mittleren Bereich, wo der Draht zugeführt wird, eine größere Breite hat als an seinen beiden Enden, über die das Verdampferschiffchen mit elektrischer Energie verbunden ist. Die größere Breite im mittleren Bereich führt dazu, dass dort aufgrund des größeren Querschnittes der elektrische Widerstand geringer wird als in den übrigen Bereichen. Das hat zur Folge, dass das Verdampferschiffchen im Bereich der Drahtzuführung weniger heiß wird als in den übrigen Bereichen, wodurch ein zu schnelles Abschmelzen und damit eine Spritzerbildung ausgeschlossen werden soll.

Nachteilig bei dem bekannten Verdampferschiffchen ist es, dass dieses zur Ermöglichung einer geringeren Erwärmung im mittleren Bereich von oben her gesehen trapezförmig ausgebildet ist. Dadurch beansprucht das Verdampferschiffchen mehr Platz zu den Seiten hin, was vor allem dann nachteilig ist, wenn in einer Beschichtungsanlage mehrere Verdampferschiffchen nebeneinander angeordnet werden müssen, um ausreichend über einen größeren Bereich Metalldampf zu erzeugen. Fertigungstechnisch nachteilig ist, dass der Materialbedarf bei der Herstellung des bekannten Verdampferschiffchens unerwünscht hoch ist, da er aus einem Materialblock gefertigt werden muss, der der maximalen Breite des Verdampferschiffchens entspricht. Dadurch entsteht bei der Fertigung zwangsläufig ein hoher Materialverlust. Das führt zu hohen Kosten, weil solche Verdampferschiffchen aus teurem Material (Titanborit und Bornitrit) bestehen und in den Beschichtungsanlagen aufgrund von Verschleiß regelmäßig ausgetauscht werden müssen.

Der Erfindung liegt das Problem zugrunde, ein Verdampferschiffchen der eingangs genannten Art so auszubilden, dass ein spritzerfreies Abschmelzen des zugeführten Drahtes möglich wird, ohne dass hierzu das Verdampferschiffchen gegenüber üblichen Verdampferschiffchen breiter ausgebildet sein muss.

Dieses Problem wird erfindungsgemäß dadurch gelöst, dass das Verdampferschiffchen zum Abschmelzen des Drahtes eine höher als der Boden der Kavität liegende Heizfläche hat und dass das Verdampferschiffchen zum Abfließen des auf der Heizfläche geschmolzenen Metalls in die Kavität ausgebildet ist.

Durch diese Gestaltung wird erreicht, dass der zugeführte Draht beim Abschmelzen mehr Abstand von der Kavität hat als beim Stand der Technik und dass das abgeschmolzene Metall statt auf heiße Stellen der Kavität oder der in dieser enthaltenen Schmelze zunächst auf die Heizfläche tropft. Da diese höher als der Boden der Kavität liegt, hat sie zwangsläufig eine niedrigere Temperatur als der übrige Bereich des Verdampferschiffchens, so dass keine Spritzer infolge des Auftreffens der relativ kalten Metalltropfen auf zu heiße Bereiche des Verdampferschiffchens entstehen. Beim Abfließen der Tropfen von der Heizfläche in die Kavität erwärmen sich die Tropfen gleichmäßig, so dass es auch beim Auftreffen auf die Schmelze in der Kavität nicht zu Spritzern kommt. Weiterhin ist das Schmelzbad in diesem Bereich sehr ruhig, weil es nur zu einem geringeren Teil vom Heizwechselstrom durchflossen wird als der übrige Bereich des Verdampferschiffchens. Deshalb lassen sich dank der Erfindung Fehlstellen auf dem bedampften Material und bei Bandbeschichtungsanlagen durch Spritzer verursachte Bandrisse verhindern. Die Erfindung ermöglicht ein absolut kontinuierliches Abschmelzen des Drahtes ohne Abtropfen bei unterschiedlichen Vorschubgeschwindigkeiten (beispielsweise 500 bis 2000 mm/min) und Drahtdurchmessern (beispielsweise 1,0 mm bis 2,0 mm). Auch längere Zuführstrecken des Drahtes zwischen beispielsweise 100 und 200 mm führen zu keiner Beeinträchtigung des gleichmäßigen Abschmelzens. Zusätzlich führt die erfindungsgemäße Gestaltung zu einer geringeren Strahlungsbelastung des zu beschichtenden Substrates und zu einer Energieeinsparung für den Beschichtungsprozess.

Desweiteren verringert sich durch die wesentlich geringere Temperatur der Verschleiß an der Drahtauftreffstelle im Vergleich zu den bisher bekannten Anordnungen. Durch die weniger starken Badbewegungen und die gleichmäßigere Verteilung der Schmelze in der Kavität wird die Lebensdauer des Verdampferschiffchens zusätzlich erhöht.

Besonders vorteilhaft ist es, wenn die Heizfläche auf einer aus der Kavität ragenden Abschmelzinsel vorgesehen ist. Eine solche Insel ist sehr einfach zu erzeugen und führt dazu, dass in ihrem Bereich dem Heizstrom der zusätzliche Querschnitt der Abschmelzinsel zur Verfügung steht, wodurch in diesem Bereich die elektrische Beheizung geringer ist, was zu einem besonders ruhigen Schmelzbad im Bereich der Abschmelzinsel führt. Weil der abzuschmelzende Draht nur die Heizfläche und nicht mehr die Kavität treffen muss, vereinfacht sich dank der Erfindung die Zuführung und Positionierung des Drahtes.

Das vom Draht abschmelzende Metall verteilt sich gleichmäßig über die Fläche der Kavität, ohne dass hierzu besondere Mittel erforderlich sind, wenn die Abschmelzinsel symmetrisch in der Mitte der Kavität angeordnet ist.

Die Abschmelzinsel ist mit äußerst geringem Aufwand herstellbar und verteuert die Herstellungskosten des Verdampferschiffchens nicht wesentlich, wenn gemäß einer anderen Ausgestaltung die Abschmelzinsel durch eine Erhebung des Bodens der Kavität gebildet ist.

Ein nachträgliches Umrüsten vorhandener Verdampferschiffchen in die erfindungsgemäßen Verdampferschiffchen ist möglich, wenn die Abschmelzinsel als separates Bauteil auf den Boden der Kavität aufgesetzt ist. Eine solche Ausführungsform bietet zusätzlich den Vorteil, dass man durch die Wahl des Materials der Abschmelzinsel, durch die Gestaltung ihrer Auflage auf dem Boden der Kavität oder durch eine Zwischenschicht die Temperaturdifferenz zum Boden der Kavität beeinflussen kann. Das ermöglicht eine Anpassung an unterschiedliche Verdampfungsbedingungen und einen Austausch der Abschmelzinsel, wenn diese im Vergleich zum übrigen Verdampferschiffchen vorzeitig verschlissen sein sollte.

Der Füllstand an Metall in der Kavität zu beiden Seiten der Abschmelzinsel kann sich ausgleichen, wenn zwischen den Längsrändern der Kavität und der Abschmelzinsel auf beiden Seiten der Abschmelzinsel ein gleich großer, die vor und hinter der Abschmelzinsel liegenden Bereiche miteinander verbindender Kanal verbleibt.

Das abgeschmolzene Metall sammelt sich zunächst auf der Abschmelzinsel und fließt dann über eine schräge Fläche sanft in die Kavität, so dass Spritzer vermieden werden, wenn gemäß einer anderen Weiterbildung der Erfindung die Abschmelzinsel an ihren gegenüberliegenden, in Längserstreckung der Kavität liegenden Seiten jeweils eine schräg in die Kavität führende Ablauffläche hat und die Heizfläche in Haupterstreckungsrichtung der Kavität trogförmig gewölbt ausgebildet ist.

Für bestimmte abzuschmelzende Metalle kann es jedoch vorteilhaft sein, wenn die Verdampferfläche der Abschmelzinsel plan ausgebildet ist und nach allen Seiten hin schräg in die Kavität führende Ablaufflächen vorgesehen sind.

Der Stromfluss durch die Abschmelzinsel und damit ihre Erwärmung aufgrund des elektrischen Stromes sind besonders gering, wenn die Abschmelzinsel aus einem Material mit höherem elektrischen Widerstand als das Material des übrigen Verdampferschiffchens besteht.

Wenn zu befürchten ist, dass das Metall des abzuschmelzenden Drahtes Verunreinigungen enthält, kann man vorsehen, dass die Heizfläche mit Rückhaltemitteln zum Zurückhalten von auf der Schmelze schwimmenden Verunreinigungen ausgestattet ist. Hierdurch lässt sich vermeiden, dass solche Verunreinigungen in die Kavität gelangen. Sie sammeln sich vielmehr auf der Heizfläche, wo sie bei Stillstand der Beschichtungsanlage entfernt werden müssen.

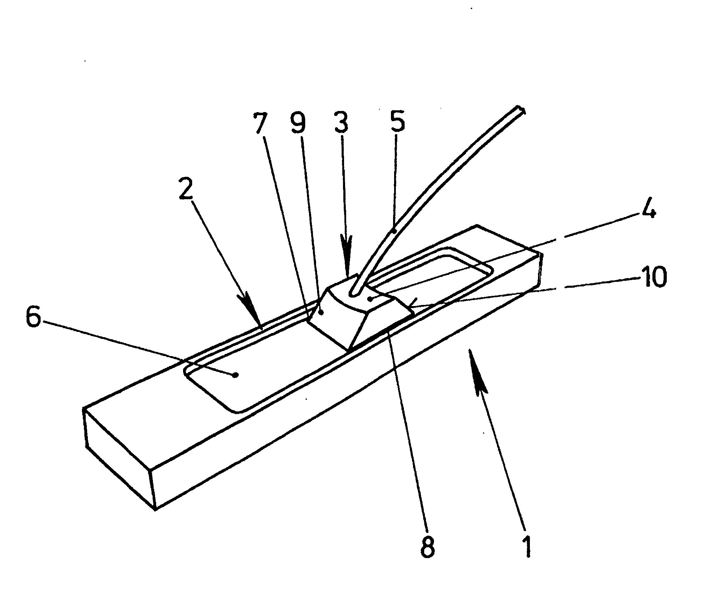

Die Erfindung lässt verschiedene Ausführungsformen zu. Zur weiteren Verdeutlichung ihres Grundprinzips ist eine davon schematisch in der Zeichnung dargestellt und wird nachfolgend beschrieben.

Die Zeichnung zeigt perspektivisch ein Verdampferschiffchen 1, welches zusammen mit mehreren weiteren Verdampferschiffchen in einer nicht gezeigten Beschichtungskammer anzuordnen ist. Zur Beheizung des Verdampferschiffchens 1 wird dieses auf übliche, ebenfalls nicht gezeigte Weise an seinen beiden Enden mit elektrischer Energie verbunden, so dass sich das Verdampferschiffchen 1 durch den Stromfluss erwärmt.

In der oberen Seite des Verdampferschiffchens 1 ist eine den größten Teil seiner Fläche einnehmende Kavität 2 ausgebildet, in der sich bei Betrieb des Verdampferschiffchen 1 das zu verdampfende Metall befindet. Wichtig für die Erfindung ist eine Abschmelzinsel 3 im mittleren Bereich der Kavität 2. Die Abschmelzinsel 3 hat eine ihre obere Seite bildende Heizfläche 4, welche zum Abschmelzen von Draht 5 dient, der auf übliche Weise kontinuierlich zugeführt wird und dessen Ende auf der Heizfläche 4 der Abschmelzinsel 3 abschmilzt.

Die Abschmelzinsel 3 kann durch eine Erhebung eines Bodens 6 der Kavität 2 gebildet sein. Möglich ist es jedoch auch, dass die Abschmelzinsel 3 als separates Bauteil auf dem Boden 6 sitzt. Die Abschmelzinsel 3 ist etwas schmaler als es der Breite der Kavität 2 entspricht. Dadurch entsteht innerhalb der Kavität 2 zu beiden Seiten der Abschmelzinsel 3 ein Kanal 7, 8, über den der vordere und rückwärtige Bereich der Kavität 2 zu beiden Seiten der Abschmelzinsel 3 miteinander verbunden ist.

Bei dem gezeigten Ausführungsbeispiel ist die Heizfläche 4 trogförmig ausgebildet, wobei ihre in Haupterstreckung des Verdampferschiffchens 1 verlaufenden Ränder höher liegen als ihr mittlerer Bereich. Nach vorn und hinten wird die Abschmelzinsel 3 jeweils von einer schräg in die Kavität 2 führenden Ablauffläche 9, 10 begrenzt. Durch diese Gestaltung fließt das vom Draht 5 abschmelzende Metall von der Heizfläche 4 nach vorn und hinten über die Ablaufflächen 9 und 10 in die Kavität 2. Vorn und hinten kann die Heizfläche auch mit jeweils einer nicht gezeigten Erhebung versehen sein, welche die Aufgabe hat, Verunreinigungen im abgeschmolzenen Metall zurückzuhalten.

Ebenfalls nicht gezeigt ist, dass die Abschmelzfläche 4 auch plan sein kann. Dann kann man nach allen vier Seiten den Ablaufflächen 9, 10 entsprechende, schräg in die Kavität 2 führende Ablaufflächen vorsehen. Vielfach kann man auch auf schräge Ablaufflächen 9, 10 gänzlich verzichten und als Abschmelzinsel 3 einfach einen würfelförmigen Klotz vorsehen.

### Bezugszeichenliste

- 1: Verdampferschiffchen
- 2: Kavität
- 3: Abschmelzinsel
- 4: Heizfläche
- 5: Draht

- 6: Boden
- 7: Kanal
- 8: Kanal
- 9: Ablauffläche
- 10: Ablauffläche

## Patentansprüche

1. Verdampferschiffchen (1) für eine Vorrichtung zur Beschichtung von Substraten in einer Beschichtungskammer, wobei das Verdampferschiffchen (1) durch direkten Stromdurchgang beheizbar ist und eine einen Boden (6) aufweisende Kavität (2) zur Aufnahme einer Schmelze des zu verdampfenden Metalles sowie eine Zuführung für das von dem Verdampferschiffchen (1) zu schmelzende und zu verdampfende Metall in Form von Draht (5) hat, **dadurch gekennzeichnet, dass** das Verdampferschiffchen (1) zum Abschmelzen des Drahtes (5) eine höher als der Boden (6) der Kavität (2) liegende Heizfläche (4) hat und dass das Verdampferschiffchen (1) zum Abfließen des auf der Heizfläche (4) geschmolzenen Metalls in die Kavität (2) ausgebildet ist.

2. Verdampferschiffchen nach Anspruch 1, **dadurch gekennzeichnet, dass** die Heizfläche (4) auf einer aus der Kavität (2) ragenden Abschmelzinsel (3) vorgesehen ist.

3. Verdampferschiffchen nach Anspruch 2, **dadurch gekennzeichnet, dass** die Abschmelzinsel (3) symmetrisch in der Mitte der Kavität (2) angeordnet ist.

4. Verdampferschiffchen nach zumindest einem der vorangehenden Ansprüche, **dadurch gekennzeichnet, dass** die Abschmelzinsel (3) durch eine Erhebung des Bodens (6) der Kavität (2) gebildet ist.

5. Verdampferschiffchen nach zumindest einem der vorangehenden Ansprüche, **dadurch gekennzeichnet, dass** die Abschmelzinsel (3) als separates Bauteil auf den Boden (6) der Kavität (2) aufgesetzt ist.

6. Verdampferschiffchen nach zumindest einem der vorangehenden Ansprüche, **dadurch gekennzeichnet, dass** zwischen den Längsrändern der Kavität (2) und der Abschmelzinsel (3) auf beiden Seiten der Abschmelzinsel (3) ein gleich großer, die vor und hinter der Abschmelzinsel (3) liegenden Bereiche miteinander verbindender Kanal (7, 8) verbleibt.

7. Verdampferschiffchen nach zumindest einem der vorangehenden Ansprüche, **dadurch gekennzeichnet, dass** die Abschmelzinsel (3) an ihren gegenüberliegenden, in Längserstreckung der Kavität (2) liegenden Seiten jeweils eine schräg in die Kavität (2) führende Ablauffläche (9, 10) hat und die Heizfläche (4) in Haupterstreckungsrichtung der Kavität (2) trogförmig gewölbt ausgebildet ist.

8. Verdampferschiffchen nach zumindest einem der vorangehenden Ansprüche, **dadurch gekennzeichnet, dass** die Heizfläche (4) der Abschmelzinsel (3) plan ausgebildet ist und nach allen Seiten hin schräg in die Kavität führende Ablaufflächen (9, 10) vorgesehen sind.

9. Verdampferschiffchen nach zumindest einem der vorangehenden Ansprüche, **dadurch gekennzeichnet, dass** die Abschmelzinsel (3) aus einem Material mit höherem elektrischen Widerstand als das Material des übrigen Verdampferschiffchens (1) besteht.

10. Verdampferschiffchen nach zumindest einem der vorangehenden Ansprüche, **dadurch gekennzeichnet, dass** die Heizfläche (4) mit Rückhaltemitteln zum Zurückhalten von auf der Schmelze schwimmenden Verunreinigungen ausgestattet ist.

## Claims

1. An evaporation boat (1) for a device for coating substrates in a coating chamber, the evaporation boat (1) being heatable by direct passage of current thrcugh it and having a cavity (2) comprising a base (6) for receiving molten metal to be evaporated, together with a feed means for the metal to be melted and evaporated by the evaporation boat (1) in the form of wire (5), **characterised in that** the evaporation boat (1) has a heating surface (4) positioned higher than the base (6) of the cavity (2) for melting the wire (5) and **in that** the evaporation boat (1) is designed so that the metal melted on the heating surface (4) flows off into the cavity (2).

2. An evaporation boat according to claim 1, **characterised in that** the heating surface (4) is provided on a melting island (3) projecting out of the cavity (2).

3. An evaporation boat according to claim 2, **characterised in that** the melting island (3) is arranged symmetrically in the centre of the cavity (2).

4. An evaporation boat according to at least one of the preceding claims, **characterised in that** the melting island (3) is formed by an elevated portion of the base (6) of the cavity (2).

5. An evaporation boat according to at least one of the preceding claims, **characterised in that** the melting island (3) is placed on the base (6) of the cavity (2) as a separate component.

6. An evaporation boat according to at least one of the preceding claims, **characterised in that** a uniformly sized channel (7, 8) connecting the regions in front of and behind the melting island (3) remains on both sides of the melting island (3) between the lengthwise edges of the cavity (2) and the melting island (3).

7. An evaporation boat according to at least one of the preceding claims, **characterised in that** the melting island (3) has a run-off surface (9, 10) leading obliquely into the cavity (2) on each of its opposing sides located in the lengthwise extension of the cavity (2) and the heating surface (4) is curved in the manner of a trough in the main direction of extension of the cavity (2).

8. An evaporation boat according to at least one of the preceding claims, **characterised in that** the heating surface (4) of the melting island (3) is of flat construction and is provided on all sides with run-off surfaces (9, 10) leading obliquely into the cavity.

9. An evaporation boat according to at least one of the preceding claims, **characterised in that** the melting island (3) consists of a material with a higher electrical resistance than the material of the rest of the evaporation boat (1).

10. An evaporation boat according to at least one of the preceding claims, **characterised in that** the heating surface (4) is equipped with retaining means for retaining impurities floating on the molten metal.

## Revendications

1. Nacelle d'évaporation (1) pour dispositif de revêtement de substrats dans une cellule de revêtement, la nacelle d'évaporation (1) pouvant être chauffée par passage direct de courant et ayant une cavité (2) présentant un fond (6) destinée à recevoir une coulée du métal à évaporer ainsi qu'une conduite d'alimentation pour le métal se présentant sous forme de fil (5) à fondre et à évaporer, **caractérisée en ce que** la nacelle d'évaporation (1) présente pour fondre le fil (5) une surface chauffante (4) placée plus haut que le fond (6) de la cavité (2) et que la nacelle d'évaporation (1) est conçue pour faire s'écouler le métal fondu sur la surface chauffante (4) vers la cavité (2).

2. Nacelle d'évaporation selon la revendication 1, **caractérisée en ce que** la surface chauffante (4) est prévue sur un îlot de coulée (3) dépassant de la cavité (2).

3. Nacelle d'évaporation selon la revendication 2, **caractérisée en ce que** l'îlot de coulée (3) est disposé symétriquement au centre de la cavité (2).

4. Nacelle d'évaporation selon au moins l'une quelconque des revendications précédentes, **caractérisée en ce que** l'îlot de coulée (3) est constitué par une surélévation du fond (6) de la cavité (2).

5. Nacelle d'évaporation selon au moins l'une quelconque des revendications précédentes, **caractérisée en ce que** l'îlot de coulée (3) est posé en tant que composante séparée sur le fond (6) de la cavité (2).

6. Nacelle d'évaporation selon au moins l'une quelconque des revendications précédentes, **caractérisée en ce qu'**entre les bords longitudinaux de la cavité (2) et l'îlot de coulée (3), il reste sur les deux côtés de l'îlot de coulée (3) un canal (7, 8) de même taille reliant les unes aux autres les zones situées devant et derrière l'îlot de coulée (3).

7. Nacelle d'évaporation selon au moins l'une quelconque des revendications précédentes, **caractérisée en ce que** l'îlot de coulée (3) présente, sur ses côtés opposés situés dans l'extension longitudinale de la cavité (2), respectivement une surface de dégagement (9, 10) allant à l'oblique vers la cavité (2) et que la surface chauffante (4) a une conformation bombée en forme de cuvette dans le sens principal d'extension de la cavité (2).

8. Nacelle d'évaporation selon au moins l'une quelconque des revendications précédentes, **caractérisée en ce que** la surface chauffante (4) de l'îlot de coulée (3) a une conformation plane et que des surfaces de dégagement (9, 10) allant de tous les côtés à l'oblique vers la cavité sont prévues.

9. Nacelle d'évaporation selon au moins l'une quelconque des revendications précédentes, **caractérisée en ce que** l'îlot de coulée (3) est composé d'un matériau à résistance électrique plus élevée que celle du matériau du reste de la nacelle d'évaporation (1).

10. Nacelle d'évaporation selon au moins l'une quelconque des revendications précédentes, **caractérisée en ce que** la surface chauffante (4) est équipée de moyens de retenue servant à retenir les impuretés flottant sur la coulée.
